# EUROPEAN PATENT APPLICATION

(11) **EP 1 853 097 A2**
(43) Date of publication of application: **07.11.2007**
(21) Application number: 07107274.8
(22) Date of filing: 01.05.2007
(51) Int. Cl.: H05K 7/14, H05K 7/20

(54) **Wedgelock device for increased thermal conductivity of a printed wiring assembly**

(30) Priority: 01.05.2006 US 381030
(71) Applicant: Honeywell International Inc., Morristown NJ 07962 (US)
(72) Inventor: Clawser, Cornelius, Pinnellas Park, FL 33781 (US)
(74) Representative: Haley, Stephen

(57) **Abstract**

A wedgelock device is provided comprises a shaft, and a plurality of thermally conductive wedge segments mounted on the shaft. The wedgelock device has at least one wedge segment that is configured to move at an acute angle with respect to another wedge segment to secure a printed wiring board in the slot of a heat sink chassis. The wedgelock device provides improved thermal performance by creating additional thermal paths from the printed wiring board to the heat sink chassis.

## Description

The operation of electronic modules such as printed wiring assemblies, which include printed wiring boards having various circuit packages attached thereto, creates heat that needs to be removed through heat exchange with a heat sink. Typically, the heat sink is a chassis such as a cold plate, which contains slots for holding individual printed wiring boards. The printed wiring boards are retained in the slots by wedgelocks, which are mechanically expanding assemblies that are fastened along one surface of the printed wiring board to hold the printed wiring board in direct contact with the cold plate.

Conventional wedgelocks that are used to secure conduction cooled printed wiring assemblies to a chassis provide limited thermal conductivity due to restricted thermal paths within the wedgelocks. These wedgelocks expand in a direction perpendicular to the wedgelock mounting surface of the printed wiring board. Thermal transfer is also limited by the thermal resistance of the board material. In addition, effective thermal conduction to the chassis is restricted to the contact area at two edges of one surface of the printed wiring board.

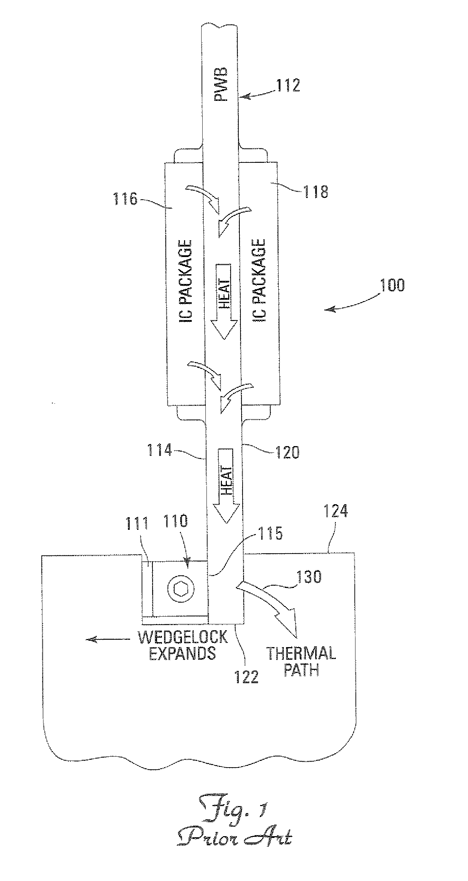

Figure 1 is a schematic end view of a conventional printed wiring assembly (PWA) 100, with a wedgelock 10 affixed to a printed wiring board (PWB) 112. The wedgelock 110 is affixed to a first side 114 of PWB 112 at a distal end mounting surface 115 thereof. The wedgelock 110 has at least one wedge component 111 that expands in a direction perpendicular to mounting surface 115 of PWB 112 to secure PWB 112 in place. An integrated circuit (IC) package 116 is attached and wired to first side 114, and an IC package 118 is attached and wired to an opposite second side 120 of PWB 112. The wedgelock 110 and PWB 112 are inserted into a slot 122 of a chassis 124 such as a cold plate, As shown, during operation of IC packages 116 and 118 heat is transferred into PWB 112, with the heat traveling into chassis 124 primarily along thermal path 130.

### IN THE DRAWINGS

Features of the present invention will become apparent to those skilled in the art from the following description with reference to the drawings. Understanding that the drawings depict only typical embodiments of the invention and are not therefore to be considered limiting in scope, the invention will be described with additional specificity and detail through the use of the accompanying drawings, in which:
Figure is a schematic end view of a conventional wedgelock used with a double-sided printed wiring board;
Figure 2 is a schematic end view of an electronic assembly including an angled wedgelock device according to one embodiment of the invention;
Figure 3 is a schematic end view of an electronic assembly including an angled wedgelock device according to another embodiment of the invention;
Figure 4 is a schematic end view of an electronic assembly including an angled wedgelock device according to an alternative embodiment of the invention;
Figure 5 is a perspective view of an angled wedgelock device according to one embodiment of the invention;
Figures 6A and 6B are side and end views of the wedgelock device of Figure 5 in a relaxed position before expansion;
Figures 7A and 7B are side and end views of the wedgelock device of Figure 5 in an expanded position;
Figures 8A and 8B are exploded top and side views of the wedgelock device of Figure 5;
Figure 9 is an end view showing the expansion direction of a conventional wedgelock; and
Figure 10 is an end view showing the expansion direction of an angled wedgelock device of the invention.

In the following detailed description, embodiments are described in sufficient detail to enable those skilled in the art to practice the invention. It is to be understood that other embodiments may be utilized without departing the scope of the present invention. The following detailed description is, therefore, not to be taken in a limiting sense.

The present invention is directed to a wedgelock device that provides improved thermal performance by creating additional thermal paths from a printed wiring assembly to a chassis. The wedgelock device has at least one wedge segment that expands at an acute angle with respect to another wedge segment, such that heat is allowed to travel through the expanded wedge segment directly into the chassis.

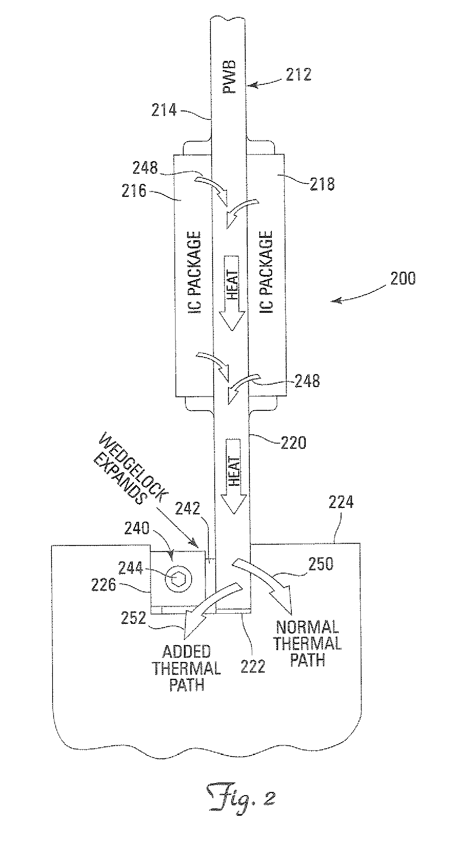

Figure 2 is a schematic end view of an electronic assembly 200, including a wedgelock device used with a printed wiring assembly (PWA), according to one embodiment of the invention. As shown, electronic assembly 200 includes a double-sided printed wiring board (PWB) 212 having a first side 214. A first integrated circuit (IC) package 216 is attached and wired to first side 214. A second IC package 218 is attached and wired to an opposite second side 220 of PWB 212 to produce the PWA. The PWB 212 is inserted into a slot 222 of a heat sink chassis 224 such as a cold plate. The slot 222 is defined by a sidewall 226. The width of slot 222 is such that it exceeds the width of PWB 212.

An angled wedgelock device 240 is mounted to chassis 224 at a mounting surface of sidewall 226 by a conventional fastener or adhesive. The wedgelock device 240 has a plurality of wedge segments with at least one wedge segment 242 that expands or moves at an acute angle with respect to the mounting surface of sidewall 226 to secure PWB 212 in slot 222. For example, wedgelock device 240 can be configured such that wedge segment 242 expands at an angle of about 45 degrees with respect to the mounting surface of sidewall 226. The wedgelock device 240 has a shaft 244, such as a screw with a threaded end portion, extending through the wedge segments.

The wedgelock device 240 can be fabricated by a conventional machining process from aluminum, an aluminum alloy, or other thermally conductive materials. The wedgelock device can include as few as three segments, but any practical number of segments can be used. A low friction surface plating or coating can be applied to the wedgelock device, improving its ability to slide along surfaces until it achieves intimate contact with both the chassis wall and the printed wiring board. Suitable low friction plating or coating materials include nickel plating, hard anodizing of aluminum or an aluminum alloy material, polytetrafluoroethylene (TEFLON) coating, and the like. Additional details related to the structure of the wedgelock device are described hereafter.

As depicted in Figure 2, during operation of IC packages 216 and 218 heat is transferred into PWB 212 along multiple thermal paths 248, with the heat traveling into chassis 224 along a first thermal path 250 and at least one added thermal path 252. The expanded segment 242 of wedgelock device 240 contacts both PWB 212 and chassis 224 to create thermal path 252.

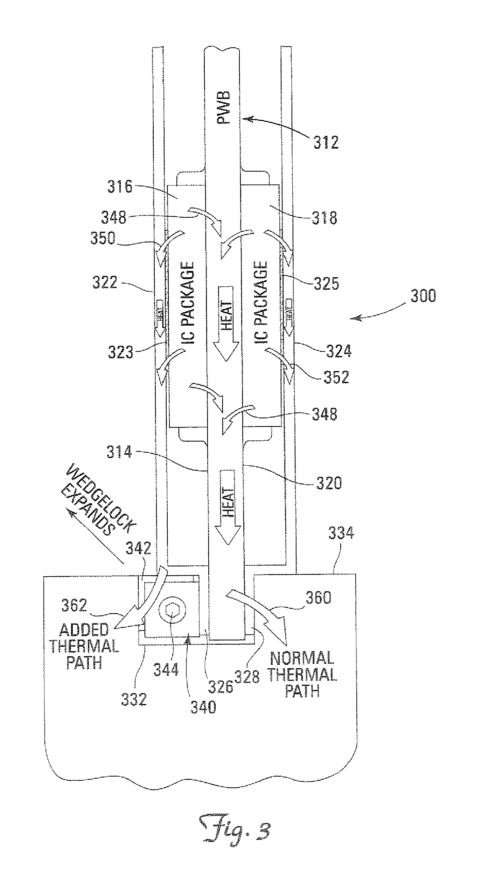

Figure 3 depicts an electronic assembly 300 including a wedgelock device used with a PWA according to another embodiment of the invention. As shown, electronic assembly 300 includes a double-sided PWB 312 having a first side 314. A first IC package 316 is attached and wired to first side 314. A second IC package 318 is attached and wired to an opposite second side 320 of PWB 312 to produce the PWA. A first thermal bridge cover 322 is disposed over first side 314 and is in thermal contact with IC package 316 through a bridge 323. A second thermal bridge cover 324 is disposed over second side 320 and is in thermal contact with IC package 318 through a bridge 325. The thermal bridge cover 322 has a narrowed end portion 326 in contact with a distal portion of first side 314, and thermal bridge cover 324 has a narrowed end portion 328 in contact with a distal portion of second side 320. The thermal bridge covers are composed of a thermally conductive material such as aluminum, an aluminum alloy, copper, a copper alloy, a carbon composite, and the like.

An angled wedgelock device 340 is affixed to a mounting surface of end portion 326 of thermal bridge cover 322 by a conventional fastener or adhesive. The PWB 312 along with end portions 326, 328 and wedgelock device 340 are inserted into a slot 332 of a heat sink chassis 334. The wedgelock device 340 has at least one segment 342 that expands at an acute angle with respect to the mounting surface of end portion 326 to secure PWB 312 in slot 332. For example, wedgelock device 340 can be configured such that segment 342 expands at an angle of about 45 degrees away from the mounting surface of end portion 326. The wedgelock device 340 has a shaft 344, such as a screw with a threaded end portion.

As shown in Figure 3, during operation of IC packages 316 and 318 heat is transferred into PWB 312 along multiple thermal paths 348. Heat is also transferred into thermal bridge covers 322 and 324 along thermal paths 350 352, respectively. The heat from PWB 312 and thermal bridge cover 324 travels into chassis 334 along a first thermal path 360. The heat from thermal bridge cover 322 travels into chassis 334 along at least one added thermal path 362 provided by the expanded segment 342 of wedgelock device 340.

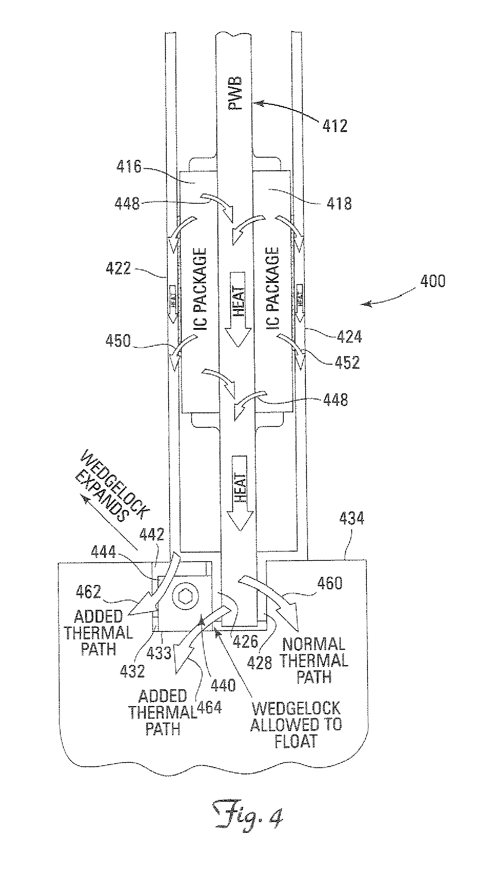

Figure 4 depicts an electronic assembly 400 having similar features as shown for electronic assembly 300 in Figure 3, but used in conjunction with a wedgelock device according to an alternative embodiment that provides an additional thermal path. As shown, electronic assembly 400 includes a double-sided PWB 412, with an IC package 416 attached at one side, and an IC package 418 attached to an opposite side of PWB 412. A thermal bridge cover 422 is in thermal contact with IC package 416, and a thermal bridge cover 424 is in thermal contact with IC package 418. The thermal bridge cover 422 has a narrowed end portion 426, and thermal bridge cover 424 has a narrowed end portion 428, both in contact with a distal portion of PWB 412.

An angled wedgelock device 440 is inserted into a slot 432 of a heat sink chassis 434 and is allowed to "float" such that it is not attached to chassis 434 or PWB 412 when PWB 412 is inserted into slot 432. The wedgelock device 440 has at least one segment 442 that expands or moves at an acute angle with respect to end portion 426 to secure PWB 412 in slot 432. The "floating" unattached configuration of wedgelock device 440 allows an unexpanded segment 444 to settle against a bottom surface 433 of slot 432. The segment 444 also abuts against end portion 426 when segment 442 is expanded.

As shown in Figure 4, during operation of IC packages 416 and 418 heat is transferred into PWB 412 along multiple thermal paths 448. Heat is also transferred into thermal bridge covers 422 and 424 along multiple thermal paths 450 and 452, respectively. The heat from PWB 412 and thermal bridge cover 424 travels into chassis 434 along a first thermal path 460. The heat from thermal bridge cover 422 travels into chassis 434 along at least one second thermal path 462 created by the expanded segment 442 of wedgelock device 440. At least one third thermal path 464 is provided by the "floating" unattached configuration of wedgelock device 440. The thermal path 464 allows heat to travel from PWB 412 into end portion 426 and through segment 444 into chassis 434.

It should be understood that additional similar thermal can be provided in the foregoing embodiments depending upon the number of segments added to the wedgelock devices. Also, the foregoing wedgelock device configurations can be used in conjunction with single-sided printed wiring boards having an IC package on one side.

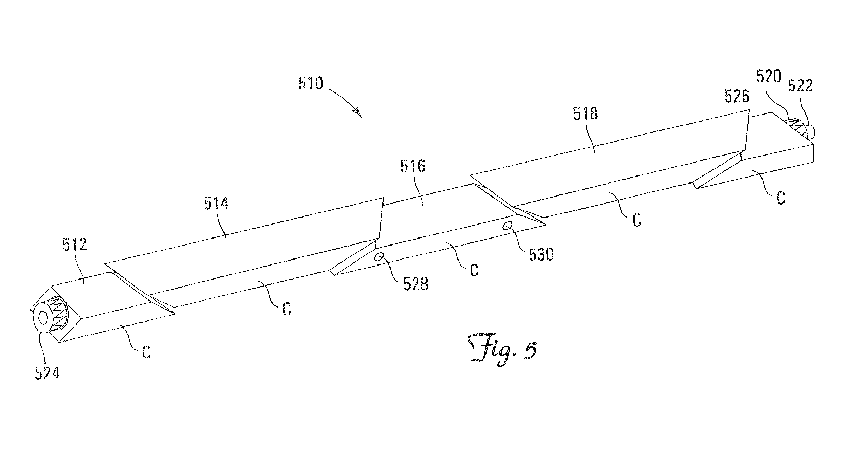

Figure 5 illustrates an angled wedgelock device 510 according to one embodiment of the invention, in which a plurality of wedge segments are utilized. The wedgelock device 510 includes a front wedge 512, a first expandable wedge 514, a middle wedge 516, a second expandable wedge 518, and a rear wedge 520. The wedge segments are mounted onto a shaft such as an elongated screw 522 that is threaded at a distal end portion thereof. The wedges 512, 514, 516, and 518 each have an aperture therethrough that allows them to slide onto screw 522. The screw 522 thus runs through all of these wedge segments and engages a threaded aperture in rear wedge 520. All of the apertures are completely surrounded by four surface portions of the wedge segments.

The screw 522 has a head 524 such as a hex socket drive at a proximal end opposite from the threaded portion of screw 522. The screw 522 is smooth and unthreaded for most of its length, allowing wedges 512, 514, 516, and 518 to slide back and forth on screw 522 until it is tightened into rear wedge 520. The rear wedge 520 has a threaded end portion 526 through which screw 522 protrudes when tightened.

When wedgelock device 510 is attached to a mounting surface, wedge 516 can be attached to the mounting surface with an adhesive, or by using connecting apertures 528 and 530 to mate with screws, rivets, and the like. When wedge 516 is mounted, the other wedge segments can move toward and away from wedge 516, allowing for the staggered, expanded configuration of wedgelock device 510 as depicted in Figure 5.

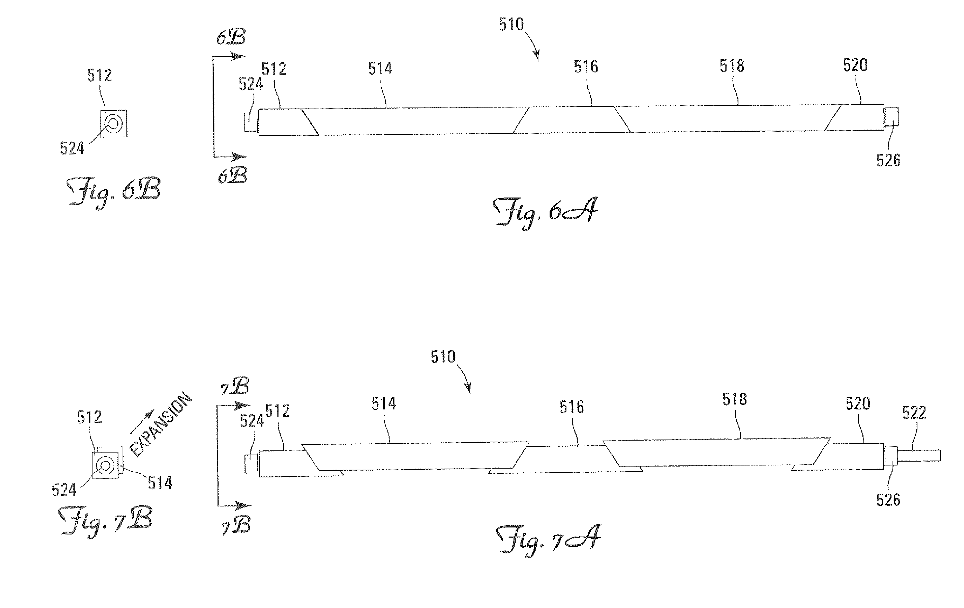

Figures 6A and 6B show side and end views of wedgelock device 510 in a relaxed position before expansion, with all of the wedges 512, 514, 516, 518, and 520 flush with each other. Figures 7A and 7B depict side and end views of wedgelock device 510 in the expanded position, with wedge segments 514 and 518 moved at an acute angle (*e,g.,* 45°) with respect to the other wedge segments.

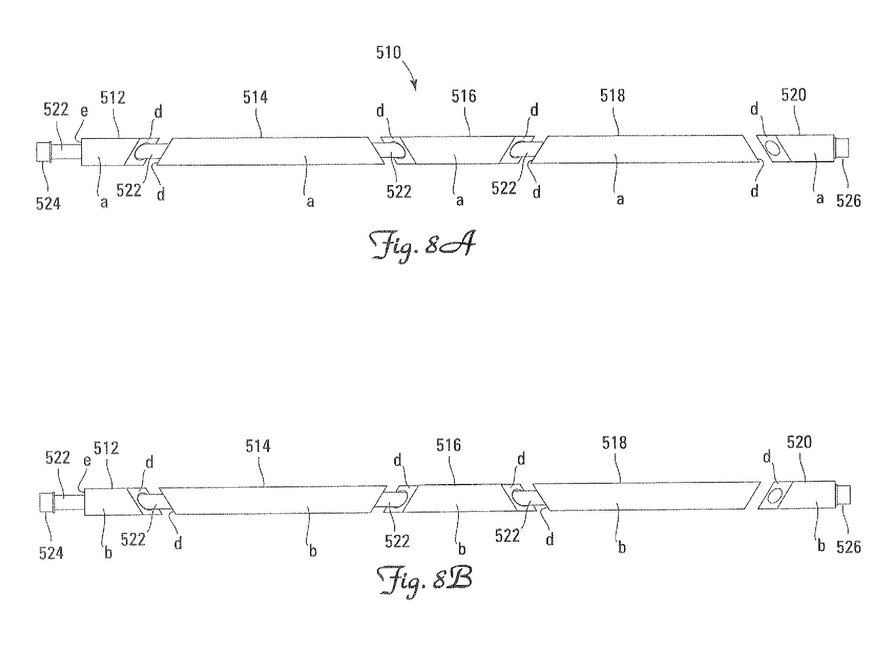

Figures 8A and 8B show exploded top and side views, respectively, of wedgelock device 510. As shown in Figure 8A, each of the wedges 512, 514, 516, 518, and 520 has a top surface *a* that is planar and trapezoidal in shape. As shown in Figure 8B, each of the wedge segments has a side surface *b* that is planar and trapezoidal in shape. Each of the wedge segments also has a side surface opposite from side surface *b* that is planar and trapezoidal in shape. Figure 5 shows that each wedge segment also has a bottom surface c that is planar and trapezoidal in shape like the top surfaces *a*.

As a result of the trapezoidal shape of the top, bottom, and two side surfaces of wedges 512, 514, 516, 518, and 520, the wedge segments have angled ramp ends *d,* depicted in Figures 8A and 8B. The angled ramp ends *d* of the wedge segments are configured so that they easily slide past a facing ramp end, creating the staggered, angled configuration shown in Figures 5 and 7A when the wedge segments are compressed together by tightening screw 522. This increases the effective width of wedgelock device 510, allowing wedgelock device 510 to adjustably apply retaining pressure against the walls of the slots of a chassis such as a cold plate. The wedge segment 512 is configured with an unramped end *e* so that head 524 may apply pressure equally to compress the various wedge segments together.

The number and length of the wedge segments can be varied in accordance with the type or size of wedgelock device desired. Thus, wedge segments may be added or subtracted, with their number not being limited to the five segments shown in Figure 5. For example, if a shorter wedgelock device than that shown in Figure 5 is desired, one or more of the wedge segments may be eliminated or another shorter segment may be substituted. On the other hand, if a longer wedgelock device is required, additional wedge segments may be added or similarly, another longer segment may be substituted.

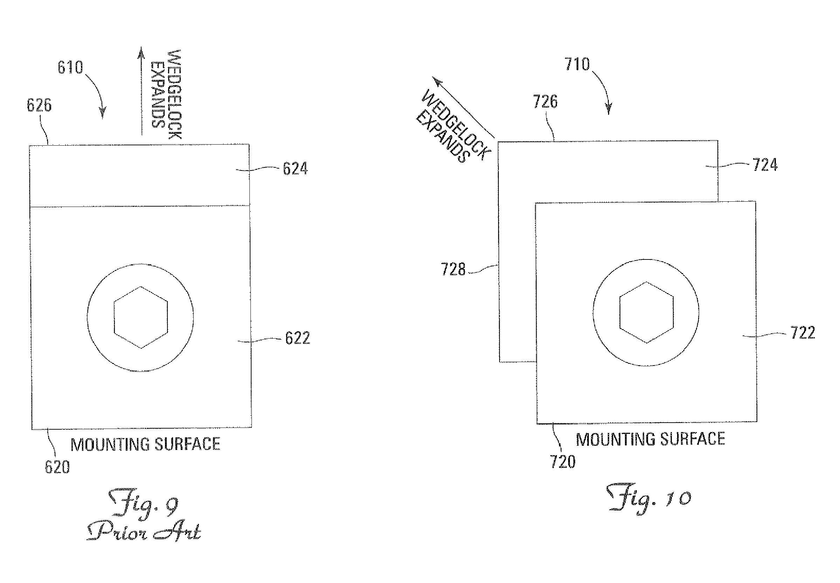

Figures 9 and 10 respectively illustrate the difference in expansion directions of a conventional wedgelock 610 and an angled wedgelock device 710 of the invention. The wedgelock 610 shown in Figure 9 has a mounting surface 620 on a wedge component 622. The wedgelock 610 also has a wedge component 624 with a single contact surface 626. The wedge component 624 expands in a direction perpendicular to mounting surface 620.

The wedgelock device 710 shown in Figure 10 has a mounting surface 720 on a first wedge segment 722. The wedgelock 710 also has a second wedge segment 724 with a contact surface 726 and an additional contact surface 728. The wedge segment 724 is configured to move in the direction of an acute angle with respect to the position of mounting surface 720. The angled movement of wedge segment 724 provides the additional contact surface 728, effectively doubling the thermal path surface area provided by wedgelock device 710 in comparison to wedgelock 610.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. A wedgelock device, comprising:
a shaft; and
a plurality of thermally conductive wedge segments mounted on the shaft;
wherein at least one of the wedge segments is configured to move at an acute angle with respect to at least one of the other wedge segments.

2. The wedgelock device of claim 1, further comprising a low friction surface plating or coating on the wedge segments.

3. The wedgelock device of claim 1, wherein the wedge segments each have four surfaces that are a trapezoidal shape.

4. The wedgelock device of claim 1, wherein the wedge segments each have at least one angled ramp end.

5. The wedgelock device of claim 1, wherein the shaft is an elongated screw with a threaded portion at one end.

6. The wedgelock device of claim 1, wherein the at least one of the wedge segments has two adjacent contact surfaces that are configured to provide a thermal path between a printed wiring assembly and a heat sink chassis.

7. The wedgelock device of claim 6, wherein the heat sink chassis has at least one slot.

8. The wedgelock device of claim 7, wherein the printed wiring assembly comprises:
a printed wiring board including a first side, and an end portion that is disposed in the slot; and
at least one integrated circuit package attached and wired to the first side of the printed wiring board.

9. The wedgelock device of claim 8, wherein a thermal bridge cover is disposed over the first side and in thermal communication with the integrated circuit package, the thermal bridge cover having an end portion disposed in the slot.

10. The wedgelock device of claim 9, wherein the wedgelock device is configured to be disposed in the slot in an unattached configuration.
